(19) Europäisches Patentamt / European Patent Office / Office européen des brevets

(11) **EP 3 242 139 B1**

(12) **EUROPEAN PATENT SPECIFICATION**

(45) Date of publication and mention
of the grant of the patent:
**13.06.2018 Bulletin 2018/24**

(51) Int Cl.:
*G01R 33/035* [(2006.01)]     *G01R 33/12* [(2006.01)]

(21) Application number: **16168375.0**

(22) Date of filing: **04.05.2016**

(54) **METHOD AND APPARATUS FOR DETERMINING A MAGNETIC FIELD**

VERFAHREN UND VORRICHTUNG ZUR BESTIMMUNG EINES MAGNETFELDES

PROCÉDÉ ET APPAREIL POUR DÉTERMINER UN CHAMP MAGNÉTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**08.11.2017 Bulletin 2017/45**

(73) Proprietor: **Julius-Maximilians-Universität
Würzburg
97070 Würzburg (DE)**

(72) Inventors:
• **Münzhuber, Franz
78315 Radolfzell am Bodensee (DE)**
• **Kleinlein, Johannes
97346 Iphofen (DE)**
• **Kießling, Tobias
97084 Würzburg (DE)**
• **Molenkamp, Laurens
97074 Würzburg (DE)**

(74) Representative: **Lucke, Andreas
Boehmert & Boehmert
Anwaltspartnerschaft mbB
Pettenkoferstrasse 22
80336 München (DE)**

(56) References cited:
**US-A1- 2010 308 813     US-A1- 2014 104 008**

• **A. COOPER ET AL: "Time-resolved magnetic
sensing with electronic spins in diamond",
NATURE COMMUNICATIONS, vol. 5, 24 January
2014 (2014-01-24), XP055153062, DOI:
10.1038/ncomms4141**
• **PHAM L M ET AL: "Magnetic field imaging with
nitrogen-vacancy ensembles;Magnetic field
imaging with nitrogen-vacancy ensembles",
NEW JOURNAL OF PHYSICS, INSTITUTE OF
PHYSICS PUBLISHING, BRISTOL, GB, vol. 13, no.
4, 28 April 2011 (2011-04-28) , page 45021,
XP020189077, ISSN: 1367-2630, DOI:
10.1088/1367-2630/13/4/045021**

EP 3 242 139 B1

**Description**

The disclosure relates to a method and an apparatus for determining a magnetic field.

Background

The negatively charged nitrogen-vacancy (NV) center in diamond has attracted enormous research interest in the last decade because of its formidable versatility in photonic applications. In addition to its suitability as quantum information processing tool, quantum cryptography element and frequency standard, the defect is a prospective candidate for the realization of quantum sensors for a wide band of physical parameters, such as temperature, acceleration, pressure, electric, and in particular magnetic fields. The single atom-like defect embedded in a controllable, but nearly non-interacting solid state environment enables the construction of spatial and magnetic field resolution. Previously proposed schemes build on established scanning probe technology and add the magnetic field sensitivity of an atomic gas sensor, which promises insight into new physics.

Magnetometry with NV centers is based on optically detected magnetic resonance (ODMR) spectroscopy of the field-sensitive spin states of the defect. The multiplicity of the electronic ground state of the NV center is $S = 1$. The three resulting eigenstates along the quantization axis, which is set by the crystallographic orientation of the NV axis, are usually labeled as $|m_s = -1,0,1\rangle$. Due to crystal field splitting the $|\pm 1\rangle$-states are energetically shifted from the $|0\rangle$-state. Optical excitation of the center as well as subsequent optical recombination are spin conserving. As crucial ingredient, the optical intensity of the $|\pm 1\rangle$-states is weaker than the optical intensity of to the $|0\rangle$-state because of an additional recombination channel in the infrared for this configuration. Therefore, the intensity of the optical photoluminescence (PL) signal can serve as a measure for the NV spin state. For an external magnetic field $B_{ext}$ parallel or antiparallel to the NV axis, the energetic shift of the states is described by the Zeeman term

$$\Delta E_{Zeeman} = g\, \mu_B\, B_{ext}\, S_z \quad (1)$$

where g is the electron g-factor, $\mu_B$ the Bohr magneton and $S_z$ the projection of the spin along the quantization axis. Accordingly, only the energetic position of $|\pm 1\rangle$-states changes as a function of the external field.

Direct transitions from $|0\rangle \rightarrow |\pm 1\rangle$ can be introduced via the application of a microwave (MW) field, which matches the splitting between the states in energy. Because splitting is sensitive to the magnetic field at the site of the NV center, the local magnetic field can be probed via the MW frequency needed to induce an ODMR Signal.

Two approaches for NV center based magnetometers can be found in the literature. Using a single NV center allows a spatial resolution given by the Bohr radius of the defect, which is on the nm scale. In this configuration only the projection of the magnetic field vector along the NV axis can be measured. Determining the other components of the field vector thus requires more than one sensor.

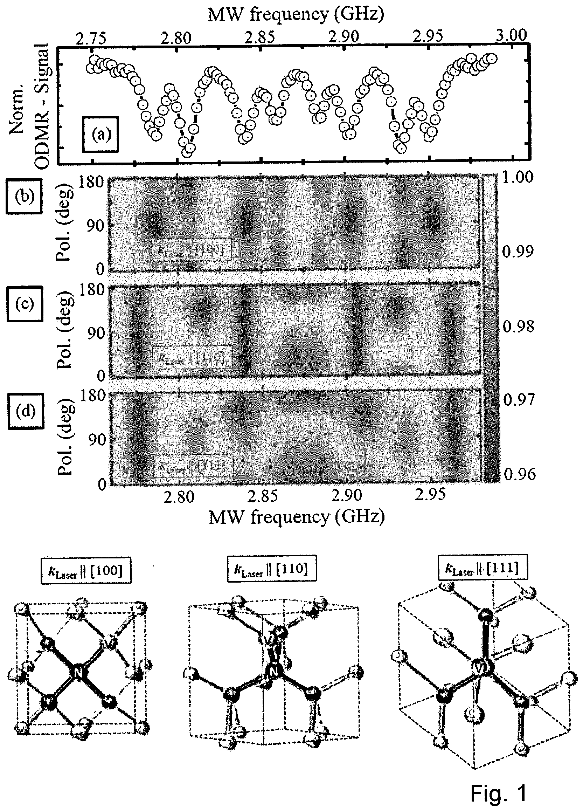

The second approach employs an ensemble of NV centers. The NV centers are oriented along the four crystallographic axes within the diamond lattice. A given magnetic field will obviously have different projections along these distinct axes. With all four possible NV orientations present in the observation volume, all field vector components can be measured with the same probe in one run. The high information density of the resulting ODMR spectrum is, however, not straightforward to analyze. A pure spectrum as depicted in Fig. 1 (a) a priori contains no information which pair of the resulting eight resonances belongs to which NV orientation. Without further input, the correct reconstruction of the magnetic field vector is impossible.

In principle, an additional bias field that has different projections along the four NV axes can be used to identify the resonances. However, it may not always be desirable to expose the investigated sample to a magnetic bias field.

Document US 2010/0308813 A1 discloses a magnetometer for sensing a magnetic field including a solid state electronic spin system, and a detector. The solid state electronic spin system comprises NV centers in diamond. The electronic spins are excited by optical radiation in order to align with a magnetic field in response thereto. The electronic spins are induced to precess about the magnetic field to be sensed, in response to a microwave field. The detector is configured to detect output optical radiation from the electronic spins, so as to determine a Zeeman shift and the magnetic field.

Document US 2014/0104008 A1 discloses a device and a method of frequency generation using an atomic resonator. The method includes using optical detected magneto-resonance in order to determine a magnetic field.

Document A. Cooper et al., "Time-resolved magnetic sensing with electronic spins in diamond", Nature Communications, 5:3141 (2014) discloses quantum probes for measuring time-varying fields with high sensitivity and spatial resolution.

Document L. M. Pham et al., "Magnetic field imaging with nitrogen-vacancy ensembles", New Journal of Physics, Volume 13 (2011) 045021 discloses a method of imaging spatially varying magnetic fields using a thin layer of nitrogen-vacancy centers at the surface of a diamond chip.

Summary

It is an object to provide improved techniques for determining a magnetic field. In particular, exposing a sample to be investigated to a magnetic bias field shall be avoided.
A method for determining a magnetic field according to claim 1 and an apparatus for determining a magnetic field according to claim 6 are provided. Further embodiments are subject matter of dependent claims.
The method allows vector magnetometry for determining the strength and the direction of a magnetic field without applying a bias magnetic field. The method may be used for:

- spatially resolved analysis of a remanence and / or a remanence field distribution in ferromagnetic samples,
- spatially resolved analysis of the field characteristics of magnetic domain walls in magnetically relaxed systems, e.g. memory media like hard disks and random access memory (RAM),
- spatially resolved analysis of the field characteristics of biological systems, e.g. magnetotactic bacteria or magnetized cells, without influence of an external static field on the system,
- complementary technology for magnetic resonance imaging, and
- analysis of samples comprising metals or metal alloys without influence on the metals / metal alloy by static fields or thermal heating due to induced currents.

The probe may be made completely of diamond. The plurality of NV centers can also be called an ensemble. The plurality of NV centers may be formed close to the surface of the probe.
The probe may be simultaneously irradiated with polarized light and with polarized microwave radiation.
The sample can be ferromagnetic or antiferromagnetic.
The light source may be a laser configured to emit laser light.
Scanning the probe may comprise moving the probe and the sample relative to each other and irradiating the probe with the polarized light while moving the probe and the sample relative to each other, or moving the light source and the probe relative to each other while irradiating the probe with the polarized light.
The probe may be formed as a substrate on which the sample is arranged. In this case, the probe can be a sample holder for the sample.
The probe may be formed as a tip. The tip may be moved across a surface of the sample while the tip is irradiated with polarized light.
Features described in the context of the method can also be applied to the apparatus and vice versa.

Description of exemplary embodiments

Following, exemplary embodiments are described.

Fig. 1     shows a NV ensemble ODMR spectrum in an external magnetic field,
Fig. 2     shows an ODMR signal as a function of MW frequency,
Fig. 3     shows measurement values for an ODMR signal,
Fig. 4     shows ODMR spectra as a function of laser polarization,
Fig. 5     shows a comparison between a measured and a simulated stray field distribution of a micromagnet,
Fig. 6     shows a schematic representation of a first embodiment of an apparatus for determining a magnetic field, and
Fig. 7     shows a schematic representation of a second embodiment of the apparatus.

In more detail:

Fig. 1 shows: (a) a NV ensemble ODMR spectrum in external magnetic field. The field orientation is chosen such that each of the eight possible resonances is clearly resolved. (b) an ODMR signal as a function of the MW frequency and the orientation angle of the linear polarization excitation plane. A horizontal cut resembles an ODMR spectrum as shown in (a). The pairwise appearance of resonances under variation of the polarization angle is characteristic for the light, incident along the direction of the [100]-crystallographic axis. (c) Same as (b) for light incident along the [110]-axis. The contribution from two NV orientations can be clearly assigned, the two other remain indistinguishable, (d) Same as (b) for light incident along the [111]-axis. Each of the four NV orientations gives a unique response to the variation of the laser polarization. In the lower portion: Schematic view of the diamond lattice along the [100]- (left), [110]- (center), and [111]- (right) crystallographic axis for better visualization.

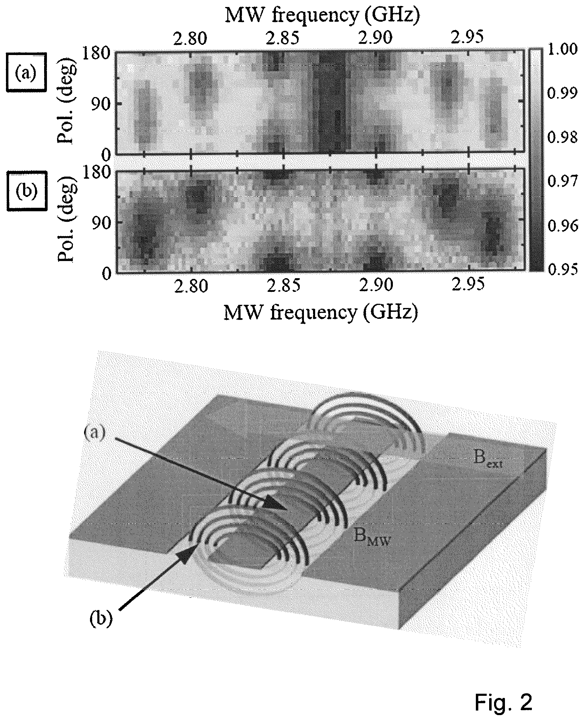

Fig. 2 shows: (a), (b) an ODMR signal as a function of the MW frequency and the angle of the linearly polarized excitation laser light at different locations above the waveguide. The positions as well as the orientations of the magnetic fields are indicated in the schematic view of the coplanar waveguide below.

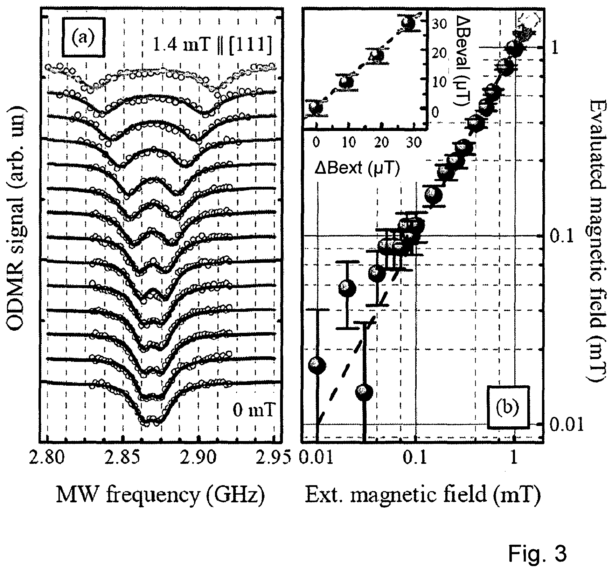

Fig. 3 shows: (a) a magnetic field response of a single NV orientation. The external field is applied along the [111]-direction. The contribution from the three other NV orientations to the ODMR spectra is negligible. (b) Robustness of the line shape analysis. At small magnetic fields ($B < 50 \, \mu T$) the influence of the transverse crystal field limits the field resolution. The inset shows how the reliability can be further increased by higher frequency sampling, when the transverse crystal field plays a minor role.

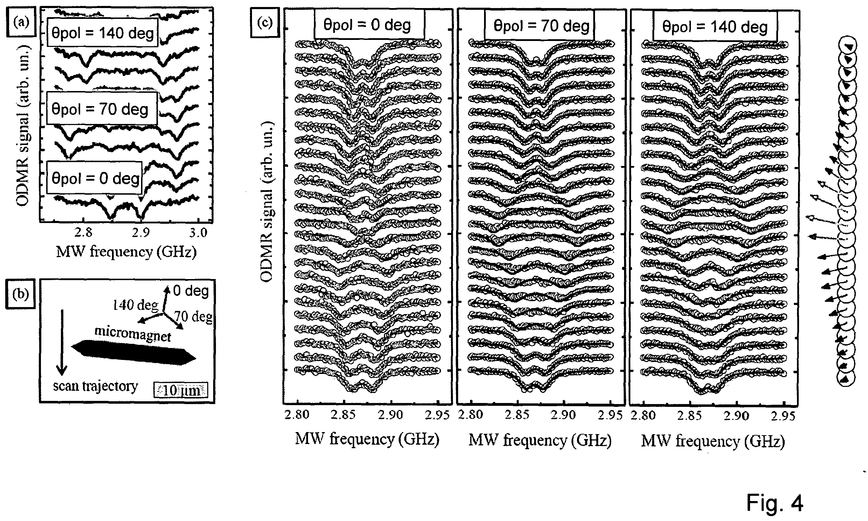

Fig. 4 shows: (a) ODMR spectra as a function of laser polarization. The spectra for each angle of laser polarization are offset for better visualization. The angles with the highest selectivity are 0° (bottom), 70° (center) and 140° (top). (b) Schematic view of the diamond surface and the structure on top of it. The scan trajectory, a scale bar, and the relative orientation of the in-plane NV axis to the structure are indicated. (c) ODMR spectra as a function of spatial position and angle of laser polarization. The step size between each measurement point is $\Delta x = 500$ nm. We recognize the individual evolution of the spectra at each angle, confirming the complete selectivity of the excitation. On the right side, a reconstruction of the magnetic field vector is shown, reproducing the supposed decay and rotation of the stray field. The length as well as the gray scale scheme corresponds to the field strength. The direction of the arrows corresponds to the direction of the field vector if translated to the trajectory in (b). The size of the circle corresponds to the detection area.

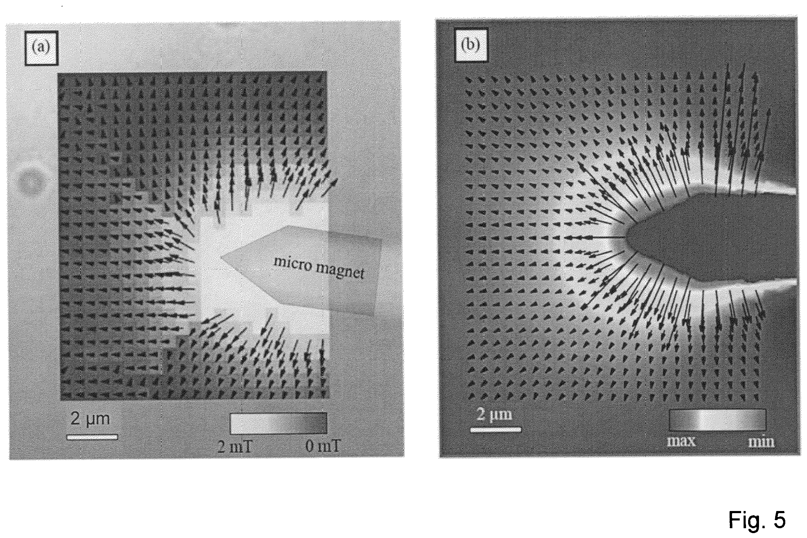

Fig 5 shows: a comparison between a measured (a) and a simulated (b) stray field distribution of a micromagnet. We recognize the white space in the measured data to be caused by the strong fields and field gradients at these grid points, rendering a measurement of local magnetic field unfeasible in the given configuration. The scan directions are not parallel to the symmetry axis of the structure in order to place the micromagnet at the appropriate position relative to the waveguide. Therefore, the grid of the experimental results is slightly rotated. The background in part (a) is a black/white image from the diamond surface, wherein the microstructure is marked.

We demonstrate all-optical vector magnetometry with an ensemble of nitrogen-vacancy centers in diamond at zero bias field. The anisotropy of the electric dipole moments of the NV center reduces the ambiguity of the optically detected magnetic resonances upon polarized visible excitation. The application of an appropriately linearly polarized microwave field enables excitation of spin-state transitions of only one single crystallographic *NV* orientation. This allows for the full vector reconstruction of magnetic fields without the need for external bias fields.

In the following, we demonstrate how the ambiguity of the resonances can be lifted by exploiting the NV center selection rules for both the excitation in the visible region and the induced transitions by the MW field.

The first prerequisite for the appearance of a specific resonance in the ODMR spectrum is an optical excitation of the NV centers along the associated crystallographic axis. We use a 532 nm diode laser system to excite the NV centers in a standard confocal geometry. The orientation of the linear polarization plane of the laser beam is tuned by the rotation of a $\lambda/2$ waveplate in the excitation path. We achieve a spatial resolution of 700 nm by employing an infinity-corrected, long working distance microscope objective and by using a pinhole as spatial filter in the detection path. The sample is placed in the center of a 3D vector magnet on a three dimensional, closed-loop translation stage, which is used to raster scan the sample position. The PL signal from the NV centers is filtered spectrally by a 690 nm $\pm$ 40 nm band pass.

The excitation efficiency is crucially determined by the coupling strength between the electric field of the laser beam and the dipole moments of electron orbitals of the NV center, which are oriented perpendicular to the NV axis and to each other. For instance, the dipole moments $d$1 and $d$2 of the [111]-oriented NV axis point along $[\bar{2}11]$ and $[01\bar{1}]$.

The probability $\Gamma$ to excite a NV center is proportional to the projection of the electric field vector $\vec{\varepsilon}$ of the incoming laser beam on its dipole moment $\vec{d}$:

$$\Gamma \propto \left| \vec{\varepsilon} \cdot \vec{d} \right|^2 \quad (2)$$

For laser incidence parallel to the [100] axis, the polarization can be rotated in the (100)-plane via the $\lambda/2$ waveplate in the excitation path. The field vector $\vec{\varepsilon}$ is then described by

$$\vec{\varepsilon} = \begin{bmatrix} 0 \\ E \sin \theta_{pol} \\ E \cos \theta_{pol} \end{bmatrix} \quad (3)$$

with $\theta_{pol}$ being the angle between the polarization and a specific axis in the (100)-plane. Accordingly, the probability $\Gamma$ is a function of the angle of laser polarization:

$$\Gamma_{d1} \propto \left\| \begin{bmatrix} 0 \\ E\sin\theta_{pol} \\ E\cos\theta_{pol} \end{bmatrix} \begin{bmatrix} 0 \\ 1/\sqrt{2} \\ -1/\sqrt{2} \end{bmatrix} \right\|^2 = \frac{E^2}{2}\left(\sin\theta_{pol} - \cos\theta_{pol}\right)^2 = \frac{E^2}{4}\cos\left(\theta_{pol} + \frac{\pi}{4}\right)^2,$$

$$\Gamma_{d2} \propto \left\| \begin{bmatrix} 0 \\ E\sin\theta_{pol} \\ E\cos\theta_{pol} \end{bmatrix} \begin{bmatrix} -2/\sqrt{6} \\ 1/\sqrt{6} \\ 1/\sqrt{6} \end{bmatrix} \right\|^2 = \frac{E^2}{6}\left(\sin\theta_{pol} + \cos\theta_{pol}\right)^2 = \frac{E^2}{12}\sin\left(\theta_{pol} + \frac{\pi}{4}\right)^2,$$

$$I \propto \Gamma_{d1} + \Gamma_{d2} \propto \frac{E^2}{4}\left(\cos\left(\theta_{pol} + \frac{\pi}{4}\right)^2 + \frac{\sin\left(\theta_{pol} + \frac{\pi}{4}\right)^2}{3}\right). \quad (4)$$

Consequently, the intensity $I$ of the optical transitions changes upon rotation of the linear polarization of the excitation.

Looking onto a (100)-facet of diamond, one can distinguish (see Fig. 1) pairs of the NV axes that have parallel projections into the observational plane. Accordingly, the resonances of these orientations appear and quench pairwise during the rotation of the linear polarization of the exciting laser beam. The number of possible NV orientations to which a resonance can be assigned is therefore reduced to two. Vice versa, a specific orientation of the polarization allows for selective NV center excitation of certain crystallographic orientations.

This principle can be further improved by using samples of diamond that show (110)- or (111)- facets. If the incident laser beam is parallel to the [110]-axis, two of the four orientations are parallel to the observational plane. According to equation 2, the angle of polarization can be chosen such that the signal from those orientations is entirely suppressed. These can, therefore, unambiguously be identified from their response to the variation of the excitation polarization, as shown in Fig. 1 (c). However, an assignment of the two remaining resonances to the two out-of- plane orientations remains unfeasible.

As demonstrated in Fig. 1 (d), illumination of the diamond along the [111]-axis allows overcoming this deficit. Three NV orientations are nearly parallel to the observational plane and the angles of laser polarization for which they are preferentially excited are at intervals of $\Delta\theta = 60°$. Only the out-of-plane orientation is constantly excited at any angle of polarization, which renders it easy to identify. In principle, all eight resonances can be assigned unequivocally to their corresponding NV orientations, i.e., all components of a magnetic field vector can be reconstructed without the need of a bias magnetic field.

In practice, this may be complicated if the magnetic fields have equal or nearly equal projections along the out-of-plane NV axis and one or more additional NV axes. In this specific case and more general for small magnetic fields, the spectral positions of the resonances heavily overlap. This renders a convincing evaluation of the ODMR spectrum very challenging. For this reason, it is highly desirable to further reduce the number NV orientations which contribute to the ODMR spectrum.

We can further enhance the directional selectivity by utilizing the optical selection rules of the microwave-induced NV spin transitions. The Hamiltonian $H^{MW}$ of the NV center spin subjected to a driving magnetic field $B^{MW}$ of frequency $\omega$ in the presence of a static magnetic field $B_{ext}$ takes the basic structure (in the rotating wave approximation)

$$H^{MW} = \begin{pmatrix} \Delta_- & \epsilon_- & 0 \\ \epsilon_-^* & 0 & \epsilon_+ \\ 0 & \epsilon_+^* & \Delta_+ \end{pmatrix} \quad (5)$$

where $\Delta_\pm = \omega_L^\pm \pm \omega$ describes the energetic detuning of the MW frequency from the Larmor frequency of the NV spin $\omega_L^\pm = D \pm \frac{g\mu_B}{h}$, which itself is set by the crystal field splitting $D$ (=2,87 GHz) and the projection $B_{ext}$ of the static magnet field along the quantization axis of the NV center (for small fields). The transitions between the $|0\rangle$ and the $|\pm 1\rangle$ states are driven by the $\epsilon_\pm \propto \left(B_x^{MW} \pm iB_y^{MW}\right)$ components. In this picture, we immediately recognize that only MW fields which have an $x$- or $y$-component in the NV basis can introduce transitions between the eigenstates and thus cause an ODMR signal.

Guiding the MW via a coplanar waveguide to the diamond, both the magnetic as well as the electric field component of the MW emitted from the waveguide are linearly polarized. The impact of the linear MW polarization is already obvious from the data shown in Fig.1. Due to the relative orientation of the MW field to the four possible NV axes, the ODMR transitions are noticeably different in amplitude.

To further demonstrate this interplay, we exploit the spatial stray field distribution near the signal lead of the waveguide structure. Depending on whether one probes directly on top of the signal or in the gap between signal and ground lines, the polarization of $B^{MW}$ is either parallel to the waveguide surface or points out of the plane. This dramatically changes the efficiency with which transitions of the out-of-plane NV orientation can be driven. In Fig. 2, we present a comparison of ODMR signals acquired at the above positions. We apply an in-plane external magnetic field in order to evidence the effect on the different transitions. This keeps the contribution of the out-of-plane NV centers at their zero-field value (the physics of the remaining splitting are discussed below). Their spectral positions therefore correspond to the situation of a low external field measurement, for which the problem of overlapping resonances occurs.

For polarization parallel to the surface we see in Fig. 2 (a) that the out-of-plane orientation dominates the spectrum. The contributions of the remaining in-plane NV orientations are strongly reduced. The weakest signal is observed from the NV orientations that experience the strongest spectral shift. This is immediately understood from equation 5. The largest shift corresponds to the largest projections of $B_{ext}$ onto one of the NV axes. As $B_{ext}$ is collinear with the polarization vector of $B^{MW}$ in this configuration, this means that the $B_x^{MW}$ and $B_y^{MW}$ components are minimized. Therefore, the MW drives transitions of this NV orientation the least.

The situation changes dramatically for out-of-plane MW fields. The formerly dominating contribution from the out-of-plane orientation is then virtually eliminated, whereas the in-plane orientations show comparable intensities.

Combined with a controlled rotation of the exciting laser polarization, we are now in a position to selectively address single NV orientations for an ensemble of NV centers, thereby lifting the inherent ambiguities which otherwise arise when working with an ensemble of NV centers. Before employing this method in a real vector magnetometry experiment, we investigate its sensitivity. To this end, we apply an external magnetic field along a given NV axis and test accuracy of the line shape analysis.

The response of the selectively excited NV centers is shown in Fig. 3 (a). For strong enough external field the spectrum explicitly confirms the excitation of only one orientation, because we can observe merely two transitions instead of four, six or eight. For very small fields we recognize a further splitting, which is not related to the applied magnetic field and persists even at zero-field value. This splitting is well understood and arises from the transverse component of the crystal field to the NV centers.

The experimental spectra in Fig. 3 (a) can be perfectly reproduced by a model function consisting of two Lorentzians with negative amplitudes. Because of the transverse crystal field splitting the spectral shift of their minima does not follow the external field linearly down to very small magnetic fields. The spectral position of the transitions can be described by

$$\Delta v = \sqrt{E_{trans}^2 + (g\mu_B B_{ext}/h\,)^2} \quad (6)$$

where $E_{trans}^2$ corresponds to the strength of the transversal crystal field.

Taking the above into account, our analysis results in a very good agreement between the actual applied field and the field values obtained from the line shape analysis. As a rough estimate, we achieve a field resolution of better than $B = 50\ \mu T$ at a spectral resolution of 1 MHz and an integration time of 200 ms.

From Fig. 3 (b) one observes a decreasing accuracy and a trend to overestimate the actual field at small fields. This is understood from the structure of equation 6. For small fields, the $E$-part dominates the spectral position and the contribution due to $B_{ext}$ is vanishing. For instance, an external field of $B = 10\ \mu T$ is expected to result in a shift of $\Delta v = 280$ kHz for an undisturbed NV center according to equation 1. In contrast, having an additional transversal field splitting of $E = 5$ MHz as in the diamond (see Fig. 3 (a)), equation 6 yields a shift of only $\Delta v = 8$ kHz.

This effect limits the achievable field resolution at small fields in the measurements. To circumvent this issue, homogenization and relaxation of the local lattice environment are required, which have been demonstrated previously to be feasible. The inset in Fig. 3 (b) shows that smaller changes in the external field can be resolved, as soon as the resonance shift occurs approximately linearly with the change of the magnetic field. The applied fields range from 1.20 mT to 1.23 mT and the sampling rate is set to 100 Hz. This enables a field resolution down to few $\mu T$.

As a demonstration of the capabilities of the technique we investigate the stray field of a ferromagnetic stripe structured on the surface of a processed sample of [111] diamond. The geometry of the structure is chosen such that change in amplitude and direction of the static $B$-field vector occur on a length scale comparable to the resolution limit.

We start by identifying the angles of laser polarization that show the highest degree of selective excitation. As shown in Fig. 4 (a), these are found at 0°, 70°, and 140°. The deviation from the expected 60° intervals arise from artifacts induced by optical elements in the setup. The beam splitter used for guiding the excitation onto the optical axis of the microscope objective and detection path, which is mandatory in confocal optical setups, has slightly different reflectivities for the $s$- and $p$-components of the incident laser beam. Therefore, the beam splitter acts for certain angles of polarization as an additional rotator.

The application of external references fields enables the determination of the orientation of the in-plane NV axes relative to the laboratory frame and the microstructure. Fig. 4 (b) indicates their relative alignment and further marks the trajectory along which we perform vector magnetometry that is shown in Fig. 4(c).

We sample a trajectory of length of $l$ = 12 $\mu$m in steps of $\Delta x$ = 500 nm for each angle of the laser polarization. The low implantation depth ($d$ = 10 nm) of the NV centers assures that the emitted signal stems only from the region directly beneath the microstructures. For this reason, we assume a perfect in-plane magnetic stray field and neglect the out-of-pane component in the further analysis.

Using the model function described above we determine the absolute values of $\Delta \nu$ for identified laser polarization angles. Being insensitive to the sign of $\Delta \nu$, the resulting value for the local field component along a specific NV orientation also only corresponds to the absolute value of the component and remains ambiguous. Only upon the comparison of the three in-plane NV orientation is the number of possible reconstructions reduced down to two, which are identical except of their sign.

This allows mapping the stray field from the microstructure. The reconstructed field vectors are shown at the right edge of Fig 4(c). We assume an evolving rotation of the field vector in order to resolve the sign-ambiguity. This last remaining question could be addressed by the application of circularly polarized MW fields, which selectively excite transitions between the $|0\rangle \rightarrow |+1\rangle$-states and the $|0\rangle \rightarrow |-1\rangle$-states.

We can finally expand the method to a two dimensional scan to investigate the complete stray field distribution. The result is shown in Fig. 5 (a). The vector field rotates around the tip of the structure. The comparison with a numerically simulated stray field distribution of such a structure as shown in Fig. 5 (b) strongly supports the reliability of the method.

It further reveals some aspects of the procedure. When the observation spot is chosen close to the magnet, two problems occur. First, the strength of the local magnet field shifts the energetic position of the $|0\rangle \rightarrow |\pm 1\rangle$-transitions out of the sampled frequency interval. Second, the field gradient along the observed defect ensemble leads to a strong broadening of the resonances in the ODMR signal. The spectra in Fig. 4(c) at the strongest energetic shift already mildly indicate these effects.

Both issues can be avoided. Adjustment of the sampled frequencies combined with nano-patterning of diamonds allow for further improvements of the disclosed method. At the same time, the utilization of nano-structured diamond samples will help to increase the overall spatial resolution.

To summarize, we demonstrated how the ambiguities of an ODMR spectrum of an ensemble of NV centers can be lifted by the application of properly polarized optical excitations. The linear polarization of the laser can reduce the number of excited NV orientation to two in case of incidence along the [111]-crystallographic axis. With help of linearly polarized MW fields, a single NV orientation can be chosen to contribute to the ODMR spectrum. The sensitivity of the method is limited by the transverse crystal field splitting E, but magnetic fields small as 50 $\mu$T can be reliably detected. This allows for the mapping of magnetic fields as is exemplified on the stray field of a ferromagnetic microstructure. The method can be applied as well to AC magnetometry schemes where higher sensitivity limits can be reached. The temperature range in which the principle is employable extends from 0 K to at least 550 K.

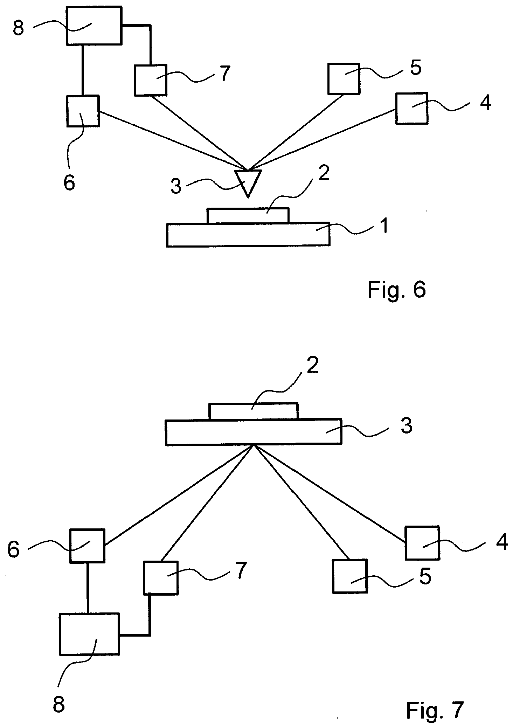

Fig. 6 shows a first embodiment of an apparatus for determining a magnetic field. The apparatus comprises a sample holder 1 which is configured for holding a sample 2. A probe 3 is arranged above the sample 3. A light source 4, e.g. a laser, emits light on the probe 3. Light reflected from the probe 3 is detected by a light detector 6. The apparatus further comprises a microwave source 5. The microwave source 5 emits microwave radiation on the probe 3. A microwave detector 7 is configured to detect microwave radiation reflected from the probe 3. The light detector 6 and the microwave detector 7 are coupled to an evaluation unit 8, e.g. a computing device comprising a processor and memory. The evaluation unit 8 is configured to evaluate the detected light and the detected microwave radiation in order to determine the magnetic field of the sample 2. The apparatus comprises a scan unit (not shown). The scan unit is coupled to the probe 3 or to the sample holder 1. The scan unit is configured to provide a relative movement between the probe 3 and the sample holder 1. In one embodiment, the scan unit is configured to move the probe 3 while the sample holder 1 with the sample 2 is kept fixed. The probe 3 may be moved in one or two dimensions in order to scan the sample 2. The light source 4 and the microwave source 5 irradiate the probe 3 while moving. In another embodiment, the scan unit is configured to move the sample holder 1 holding the sample 2 while the probe 3 is kept fixed and is irradiated by the light source 4 and the microwave source 5.

Another embodiment of the apparatus is shown in Fig. 7. Here, the sample 2 is arranged on the probe 3 which functions as probe holder. The probe 3 is irradiated by light emitted by the light source 4 and by microwave radiation emitted by the microwave source 5. Light and microwave radiation reflected from the probe 3 are detected by the light detector 6 and the microwave detector 7, respectively. Both, the light detector 6 and the microwave detector 7 are connected to the evaluation unit 8. A scan unit (not shown) is configured to move the probe in one or two dimensions in order to allow scanning the sample 2. The probe 3 is irradiated by light and microwave radiation while it is being moved,

The features disclosed in the specification, the claims and the figures can be relevant for the implementation of embodiments either alone or in any combination with each other.

**Claims**

1. A method for determining a magnetic field, comprising steps of:

   - providing a magnetic sample (2),
   - providing a probe (3) comprising diamond, wherein in the diamond a plurality of negatively charged nitrogen-vacancy centers are formed,
   - scanning the probe with polarized light, wherein the probe (3) is irradiated with light emitted by a light source (4) and light reflected from the probe (3) is detected by a light detector (6),
   - irradiating the probe (3) with polarized microwave radiation emitted by a microwave source (5) and detecting microwave radiation reflected from the probe (3) by a microwave detector (7), and
   - evaluating the detected light and the detected microwave radiation,
   ch aracteriz ed by steps of
   - arranging the light source (4) to a crystal orientation of the diamond such that the light is irradiated with a specific angle of polarization with respect to the crystal orientation, and
   - changing the polarization of the light while scanning the probe (3), and
   further **characterized in that**
   - a polarization of the microwave radiation is oriented parallel to or out-of-plane of a surface of the diamond in the probe (3).

2. The method of claim 1, wherein the light source (4) is a laser configured to emit laser light.

3. The method of one of the preceding claims, wherein scanning the probe comprises:

   - moving the probe (3) and the sample (2) relative to each other and irradiating the probe (3) with the polarized light while moving the probe (3) and the sample (2) relative to each other, or
   - moving the light source (4) and the probe (3) relative to each other while irradiating the probe (3) with the polarized light.

4. The method of one of the preceding claims, wherein the probe (3) is formed as a substrate on which the sample (2) is arranged.

5. The method of one of the claims 1 to 3, wherein the probe (3) is formed as a tip.

6. An apparatus for determining a magnetic field, comprising:

   - a sample holder (1) configured for holding a magnetic sample (2),
   - a probe (3) comprising diamond, wherein in the diamond a plurality of negatively charged nitrogen-vacancy centers are formed,
   - a scan unit configured to scan the probe with polarized light, including a light source (4) configured to irradiate the probe (3) with polarized light, and a light detector (6) configured to detect light reflected from the probe (3),
   - a microwave source (5) configured to irradiate the probe (3) with polarized microwave radiation,
   - a microwave detector (7) configured to detect microwave radiation reflected from the probe (3), and
   - an evaluation unit (8) configured to evaluate the detected light and the detected microwave radiation,
   c h ar acte r i zed in that
   - the light source (4) is arranged to a crystal orientation of the diamond such that the light is irradiated with a specific angle of polarization with respect to the crystal orientation,
   - the light source (4) is further configured to change the polarization of the light while scanning the probe (3), and
   - the microwave source (5) is further configured to emit microwave radiation with a polarization which is oriented parallel to or out-of-plane of a surface of the diamond in the probe (3).

**Patentansprüche**

1. Verfahren zum Ermitteln eines Magnetfeldes, mit den folgenden Schritten:

   - Bereitstellen einer magnetischen Probe (2)
   - Bereitstellen einer Sonde (3), die Diamant enthält, wobei in dem Diamant eine Mehrzahl von negativ geladenen Stickstoff-Vakanzzentren ausgebildet sind,
   - Scannen der Sonde mit polarisiertem Licht, wobei die Sonde (3) mit Licht bestrahlt wird, welches von einer Lichtquelle (4) emittiert wird, und von der Sonde (3) reflektiertes Licht durch einen Lichtdetektor (6) detektiert wird,
   - Bestrahlen der Sonde (3) mit polarisierter Mikrowellenstrahlung, die von einer Mikrowellenquelle (5) emittiert wird, und Detektieren von Mikrowellenstrahlung, die von der Sonde (3) reflektiert wird, mit einem Mikrowellendetektor (7), und
   - Auswerten des detektierten Lichts und der detektierten Mikrowellenstrahlung,

   **gekennzeichnet durch** die folgenden Schritte:

   - Anordnen der Lichtquelle (4) in Bezug auf eine Kristallorientierung des Diamants, so dass das Licht mit einem spezifischen Polarisationswinkel in Bezug auf die Kristallorientierung eingestrahlt wird, und
   - Ändern der Polarisierung des Lichts, während die Sonde (3) gescannt wird, und

   weiter **dadurch** gekennzeichnet, dass
   - eine Polarisation der Mikrowellenstrahlung parallel zu einer Oberfläche des Diamants in der Sonde (3) oder in einer Richtung aus der Fläche derselben heraus (out of plane) gerichtet ist.

2. Verfahren nach Anspruch 1, wobei die Lichtquelle (4) ein Laser ist, der dazu konfiguriert ist, Laserlicht zu emittieren.

3. Verfahren nach einem der vorhergehenden Ansprüche, wobei das Scannen der Sonde Folgendes umfasst:

   - Bewegen der Sonde (3) und der Probe (2) relativ zueinander und Bestrahlen der Sonde (3) mit dem polarisierten Licht, während die Sonde (3) und die Probe (2) relativ zueinander bewegt werden, oder
   - Bewegen der Lichtquelle (4) und der Sonde (3) relativ zueinander, während die Sonde (3) mit dem polarisierten Licht bestrahlt wird.

4. Verfahren nach einem der vorhergehenden Ansprüche, wobei die Sonde (3) als ein Substrat ausgebildet ist, auf dem die Probe (2) angeordnet ist.

5. Verfahren nach einem der Ansprüche 1 bis 3, wobei die Sonde (3) als eine Spitze ausgebildet ist.

6. Vorrichtung zum Bestimmen eines Magnetfeldes, die Folgendes umfasst:

   - einen Probenhalter (1), der dazu konfiguriert ist, eine magnetische Probe (2) zu halten,
   - eine Sonde (3), die Diamant enthält, wobei in dem Diamant eine Mehrzahl von negativ geladenen Stickstoff-Vakanzzentren ausgebildet sind,
   - eine Scaneinheit, die dazu konfiguriert ist, die Sonde mit polarisiertem Licht zu scannen, umfassend eine Lichtquelle (4), die dazu konfiguriert ist, die Sonde (3) mit polarisiertem Licht zu bestrahlen, und einen Lichtdetektor (6), der dazu konfiguriert ist, von der Sonde (3) reflektiertes Licht zu detektieren,
   - eine Mikrowellenquelle (5), die dazu konfiguriert ist, die Sonde (3) mit polarisierter Mikrowellenstrahlung zu bestrahlen,
   - einen Mikrowellendetektor (7), der dazu konfiguriert ist, Mikrowellenstrahlung zu detektieren, die von der Sonde (3) reflektiert wird, und
   - eine Auswertungseinheit (8), die dazu konfiguriert ist, das detektierte Licht und die detektierte Mikrowellenstrahlung auszuwerten,
   **dadurch gekennzeichnet, dass**
   - die Lichtquelle (4) in Bezug auf eine Kristallorientierung des Diamants so angeordnet ist, dass das Licht mit einem spezifischen Polarisationswinkel in Bezug auf die Kristallorientierung eingestrahlt wird,
   - die Lichtquelle (4) ferner konfiguriert ist, die Polarisation des Lichts zu ändern, während die Sonde (3) gescannt wird, und
   - die Mikrowellenquelle (5) ferner dazu konfiguriert ist, Mikrowellenstrahlung mit einer Polarisation zu emittieren, die parallel zu einer Oberfläche des Diamants in der Sonde (3) oder aus der Fläche heraus angeordnet ist.

**Revendications**

1. Procédé de détermination d'un champ magnétique, comprenant les étapes suivantes :

   - fourniture d'un échantillon magnétique (2),
   - fourniture d'une sonde (3) comprenant du diamant, où une pluralité de centres azote-lacune à charge négative sont formés dans le diamant,
   - balayage de la sonde avec une lumière polarisée, où la sonde (3) est irradiée avec une lumière émise par une source de lumière (4) et la lumière réfléchie par la sonde (3) est détectée par un détecteur de lumière (6),
   - irradiation de la sonde (3) avec un rayonnement hyperfréquence polarisé émis par une source de micro-ondes (5) et détection d'un rayonnement hyperfréquence réfléchi par la sonde (3) par un détecteur de micro-ondes (7), et
   - évaluation de la lumière détectée et du rayonnement hyperfréquence détecté,

   **caractérisé par** les étapes suivantes :

   - agencement de la source de lumière (4) selon une orientation cristalline du diamant de sorte que la lumière est irradiée selon un angle de polarisation spécifique par rapport à l'orientation cristalline, et
   - changement de polarisation de la lumière pendant le balayage de la sonde (3), et
   **caractérisé en outre en ce que**
   - une polarisation du rayonnement hyperfréquence est orientée parallèlement à une surface du diamant de la sonde (3) ou hors du plan de ladite surface.

2. Procédé selon la revendication 1, dans lequel la source de lumière (4) est un laser configuré pour émettre une lumière laser.

3. Procédé selon l'une quelconque des revendications précédentes, dans lequel le balayage de la sonde comprend :

   - le déplacement de la sonde (3) et de l'échantillon (2) l'un par rapport à l'autre et l'irradiation de la sonde (3) avec la lumière polarisée pendant le déplacement de la sonde (3) et de l'échantillon (2) l'un par rapport à l'autre, ou
   - le déplacement de la source de lumière (4) et de la sonde (3) l'une par rapport à l'autre pendant l'irradiation de la sonde (3) avec la lumière polarisée.

4. Procédé selon l'une quelconque des revendications précédentes, dans lequel la sonde (3) forme un substrat sur lequel est agencé l'échantillon (2).

5. Procédé selon l'une des revendications 1 à 3, dans lequel la sonde (3) forme une pointe.

6. Appareil de détermination d'un champ magnétique, comprenant :

   - un porte-échantillon (1) configuré pour recevoir un échantillon magnétique (2),
   - une sonde (3) comprenant du diamant, où une pluralité de centres azote-lacune à charge négative sont formés dans le diamant,
   - une unité de balayage configurée pour balayer la sonde avec une lumière polarisée, comprenant une source de lumière (4) configurée pour irradier la sonde (3) avec une lumière polarisée et un détecteur de lumière (6) configuré pour détecter la lumière réfléchie par la sonde (3),
   - une source de micro-ondes (5) configurée pour irradier la sonde (3) avec un rayonnement hyperfréquence polarisé,
   - un détecteur de micro-ondes (7) configuré pour détecter un rayonnement hyperfréquence réfléchi par la sonde (3), et
   - une unité d'évaluation (8) configurée pour évaluer la lumière détectée et le rayonnement hyperfréquence détecté, **caractérisé en ce que** :
   - la source de lumière (4) est agencée selon une orientation cristalline du diamant de sorte que la lumière est irradiée selon un angle de polarisation spécifique par rapport à l'orientation cristalline,
   - la source de lumière (4) est configurée en outre pour changer la polarisation de la lumière pendant le balayage de la sonde (3), et
   - la source de micro-ondes (5) est configurée en outre pour émettre un rayonnement hyperfréquence avec une polarisation qui est orientée parallèlement à une surface du diamant de la sonde (3) ou hors du plan de ladite surface.

Fig. 1

Fig. 2

Fig. 3

Fig. 4

Fig. 5

Fig. 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100308813 A1
- US 20140104008 A1

**Non-patent literature cited in the description**

- **A. COOPER et al.** Time-resolved magnetic sensing with electronic spins in diamond. *Nature Communications,* 2014, vol. 5, 3141
- **L. M. PHAM et al.** Magnetic field imaging with nitrogen-vacancy ensembles. *New Journal of Physics,* 2011, vol. 13, 045021